# EUROPÄISCHE PATENTANMELDUNG

(11) **EP 4 273 638 A1**
(43) Veröffentlichungstag der Anmeldung: **08.11.2023**
(21) Anmeldenummer: 23158920.1
(22) Anmeldetag: 28.02.2023
(51) Int. Cl.: G05B 17/02, G06F 30/20

(54) **VERFAHREN UND VORRICHTUNG ZUM KONFIGURIEREN EINES MODULS ZUR SIMULATION ZUMINDEST EINES SENSORS**

(30) Priorität: 03.05.2022 DE 102022110843
(71) Anmelder: dSPACE GmbH, 33102 Paderborn (DE)
(72) Erfinder: Sievers, Dr., Gregor, 33102 Paderborn (DE); Ax, Johannes, 33102 Paderborn (DE)

(57) **Zusammenfassung**

Die Anmeldung betrifft ein Verfahren zum Konfigurieren eines Moduls zur Simulation (12) zumindest eines Sensors, wobei das Modul (12) eine Sensorsimulation (16) und eine erste Datenschnittstelle erster Art (14) aufweist, wobei die Sensorsimulation (16) ausgebildet und eingerichtet ist, ein Gerät (30) zur Ausführung von Steuerungs- und/oder Regelungsaufgaben über die erste Datenschnittstelle (14) erster Art mit synthetischen Sensordaten zu versorgen. Das Verfahren weist die Schritte auf:
a) Empfangen einer Aufzeichnung (20) eines Datenaustausches eines realen Sensors (22) mit dem Gerät (30), wobei der Datenaustausch über eine zweite Datenschnittstelle (24) erster Art erfolgte, und/oder Empfangen von Informationen zu zumindest einer Eigenschaft des realen Sensors (22) und/oder der zweiten Datenschnittstelle erster Art (24),
b) Auslesen der Aufzeichnung (20) und/oder der Informationen zur zumindest einen Eigenschaft,
c) Ermitteln zumindest eines Charakteristikums (Ch) des realen Sensors (22) und/oder der zweiten Datenschnittstelle erster Art (24),
d) Konfigurieren der Sensorsimulation (16) und/oder der ersten Datenschnittstelle erster Art (14) unter Verwendung des zumindest einen Charakteristikums (Ch) so, dass die synthetischen Sensordaten Sensordaten des realen Sensors (22) simulieren.

Die Anmeldung betrifft weiter eine Vorrichtung zum Konfigurieren eines Moduls zur Simulation.

## Beschreibung

### Technisches Gebiet

Die Anmeldung betrifft ein Verfahren und eine Vorrichtung zum Konfigurieren eines Moduls zur Simulation zumindest eines Sensors. Die Anmeldung betrifft weiter ein Modul zur Simulation zumindest eines Sensors sowie ein Gerät zur Ausführung von Steuerungs- und/oder Regelungsaufgaben insbesondere für ein Fahrzeug.

### Hintergrund

Geräte zur Ausführung von Steuerungs- und/oder Regelungsaufgaben in Fahrzeugen werden auch als Steuergeräte bezeichnet. Steuergeräte in Fahrzeugen, insbesondere Kraftfahrzeugen, können eine Recheneinheit, Speicher, Schnittstellen und evtl. weitere Komponenten, aufweisen, die für die Verarbeitung von Eingangssignalen mit Eingangsdaten in das Steuergerät und die Erzeugung von Steuersignalen mit Ausgangsdaten erforderlich sind. Die Schnittstellen dienen zur Aufnahme der Eingangssignale bzw. Abgabe der Steuersignale.

Steuergeräte für Fahrfunktionen sowohl für fortgeschrittene Fahrerassistenzsysteme (ADAS = Advanced Driver Assistance Systems) als auch für autonomes oder teilautonomes Fahren, können als Eingangsdaten Sensordaten von verschiedenen Sensoren erhalten.

Eine Möglichkeit zum Test von Steuergeräten, die Sensordaten von Sensoren auswerten, besteht darin, die Steuergeräte mit den entsprechenden Sensoren im Einbauzustand - beispielsweise im Kraftfahrzeug im Rahmen von Testfahrten - zu erproben. Dies ist aufwendig, kostenintensiv und es können viele Situationen in einer echten Umgebung nicht überprüft werden, da sie nur in Extremfällen, beispielsweise bei Unfällen, auftreten. Deshalb werden entsprechende Steuergeräte in künstlichen Umgebungen, beispielsweise in Prüfständen, getestet. Ein weiteres häufiges Testszenario besteht hier darin, die Funktionalität eines Steuergeräts mittels einer simulierten Umwelt zu testen. Die Umgebungssimulation kann dabei die Simulation von realen Sensoren mittels einer Sensorsimulation umfassen. Die Sensorsimulation kann dabei synthetische Sensordaten generieren, die die virtuelle Umwelt des Steuergerätes nachbilden.

Rapid Control Prototyping (kurz: RCP) bezeichnet eine rechnergestützte Entwurfsmethode zur schnellen Regelungs- und Steuerungsentwicklung insbesondere auch für Steuergeräte im Fahrzeug. Entwurfsschritte beim RCP umfassen Prototypen verschiedener Entwurfsstadien einer Steuergerätefunktion, welche ihrerseits in Verbindung mit der Umgebung oder mit einer Umgebungssimulation getestet werden können. Typische Entwurfsschritte beim RCP umfassen die (dynamische) Beschreibung des zu automatisierenden Systems und dessen Modellbildung, den Regelungs- und Steuerungsentwurf im Modell.

Eine weitere Methode zum Testen von Steuergeräten ist der sogenannte Hardware-in-the-Loop (kurz: HIL) Test, wobei der Regelungs- und Steuerungsentwurf final auf dem Steuergerät implementiert ist und die Erprobung der Lösung in einer reinen Simulationsumgebung aber auf einem realen System erfolgt.

Bei einem sogenannten Software-in-the-Loop (kurz. SIL) Test kommt ein reales Steuergerät noch nicht zum Einsatz. Hier wird der Software Code des Regelungs- und Steuerungsentwurfs auf einem Simulator, z.B. auf einem entsprechend eingerichteten PC, im Zusammenspiel mit einem sogenannten Umgebungsmodell erprobt.

In "Sensorrealistische Simulation in Echtzeit", Caius Seiger, Dr. Gregor Sievers, HANSER Automotive 7/2020, wird eine HIL Umgebung beschrieben, die einen Kamerabildsensor einschließlich Linse ersetzt und simuliert. Die Sensorrohdaten werden über eine DisplayPort-Schnittstelle einer GPU (Graphic Processing Unit) an eine Environment Sensor Interface Unit (ESI Unit) übergeben. Die ESI-Unit ist eine FPGA-basierte Plattform, auf der modellbasiert Sensoren simuliert werden. Auf der ESI Unit werden weitere Bestandteile der Sensormodelle, z. B. eine Simulation der I2C-Schnittstelle des Kamerabildsensors, ausgeführt. Für die Übertragung der Sensorrohdaten hat sich bisher kein herstellerübergreifender Schnittstellenstandard herausgebildet. Daher muss ein Testsystem zur Sensorrohdateneinspeisung eine Vielzahl von Sensorschnittstellen unterstützen, welche entsprechend konfiguriert werden müssen.

In "Sensorsimulation in In-the-Loop-Umgebungen" Holger Krumm, ATZ 2019, wird beschrieben, die ESI Unit zur Rohdatensimulation zu verwenden, wobei eine Vielzahl von Schnittstellen unterstützt wird, welche Langstreckenschnittstellen, Kurzstellenschnittstellen und den I2C-Steurungskanal umfassen.

Durch eine Vielzahl an Sensoren mit einer Vielzahl von Konfigurationsmöglichkeiten kann daher ein hoher Aufwand an manueller Anpassung (Engineering) erforderlich sein. Durch die Anmeldung soll die Konfiguration verbessert werden.

### Übersicht

Bei einem Verfahren zum Konfigurieren eines Moduls zur Simulation zumindest eines Sensors, weist das Modul eine Sensorsimulation und eine erste Datenschnittstelle erster Art auf, wobei die Sensorsimulation ausgebildet und eingerichtet ist, ein Gerät zur Ausführung von Steuerungs- und/oder Regelungsaufgaben über die erste Datenschnittstelle erster Art mit synthetischen Sensordaten zu versorgen.

Das Verfahren weist die Schritte auf:
a) Empfangen einer Aufzeichnung eines Datenaustausches eines realen Sensors mit dem Gerät, wobei der Datenaustausch über eine zweite Datenschnittstelle erster Art erfolgte und/oder Empfangen von Informationen zu zumindest einer Eigenschaft des realen Sensors und/oder der zweiten Datenschnittstelle erster Art.

Eine Eigenschaft der zweiten Datenschnittstellen erster Art kann z. B. eine Eigenschaft eines Protokolls aufweisen. Das Protokoll betrifft insbesondere ein Kommunikationsprotokoll, gemäß dessen Regeln der Datenaustausch über die zweite Datenschnittstelle erster Art erfolgt.

Die Aufzeichnung, z. B. eine Log-Datei, kann dabei insbesondere durch eine Vorrichtung zum Konfigurieren des Moduls zur Simulation empfangen werden. Die Vorrichtung kann z.B. als PC mit einer ausführbaren Software ausgebildet sein, welche die Log-Datei einliest. Der PC kann z. B. an ein Modul zur Simulation oder mehrere Module zur Simulation angeschlossen, also z. B. kommunikativ verbunden, werden.

Die Informationen zur zumindest einen Eigenschaft des realen Sensors und/oder der zweiten Datenschnittstelle erster Art können z. B. in einer Konfigurationsspezifikation enthalten sein, welche z. B. dem realen Sensor und/oder dem Gerät zur Ausführung von Steuerungs- und/oder Regelungsaufgaben zugeordnet ist. Bei den Informationen zur zumindest einen Eigenschaft kann es sich um Informationen, insbesondere zusätzliche Informationen zum realen Sensor, z.B. Typ, Art der Schnittstelle, Information, welche Informationen, z. B. für einen Imager, in welchem Register stehen etc., und/oder um weitere Informationen zur zweiten Datenschnittstelle erster Art, z. B. zu dem Protokoll, handeln. Die Eigenschaften zur zweiten Datenschnittstelle erster Art können Eigenschaften zum Protokoll der Datenschnittstelle, also insbesondere weitere Informationen zum Protokoll umfassen.
b) Auslesen der Aufzeichnung und/oder der Informationen zur zumindest einen Eigenschaft. Bevorzugt erfolgt in diesem Schritt ein Verknüpfen der ausgelesenen Aufzeichnung mit den empfangenen Informationen zur zumindest einen Eigenschaft.

Dem Auslesen der Aufzeichnung entspricht hier z. B. ein Parsen der Aufzeichnung durch die Vorrichtung. Das kann auch als Einlesen der Aufzeichnung durch die Vorrichtung bezeichnet werden. Bei der Aufzeichnung kann es sich z. B. um eine Log-Datei mit einem vorgegebenen Format handeln. Sie kann durch das Konfigurationsprogramm eingelesen und z.B. in einer Datenbank abgelegt werden. In diesem Schritt kann außerdem eine Anreicherung mit den Informationen zur zumindest einen Eigenschaft, also mit weiteren Informationen, vorgenommen werden, wie z. B. Informationen zum Sensortyp des realen Sensors.

Die Informationen zur zumindest einen Eigenschaft können durch Empfang und Auslesen der Konfigurationsspezifikation ermittelt werden und optional in die Datenbank aufgenommen werden. Diese können dann wiederverwendet werden, z. B. für weitere Konfigurationsvorgänge oder weitere Module zur Simulation. Insbesondere kann die ausgelesene Aufzeichnung verknüpft mit den Informationen zur zumindest einen Eigenschaft in der Datenbank abgelegt werden und dann wiederverwendet oder weiterverwendet werden.

In der Log Datei befinden sich Daten insbesondere zu Schreib- und Lesezugriffen über die Schnittstelle erster Art, also insbesondere an welcher Stelle zugegriffen wurde und welche Information dort entnommen wurden. Anhand von z. B. der Information zum Sensortyp (Eigenschaft) kann ermittelt werden, um was für Daten es sich bei den übermittelten Daten der Aufzeichnung handelt und wo diese in der Aufzeichnung zu finden sind.

Das Auslesen umfasst ein Parsen der in der Aufzeichnung enthaltenen Daten anhand der Eigenschaften, also z. B. unter Zuhilfenahme der Geräteinformationen, die in der Regel zusätzlich zu dem realen Sensor und/oder Steuergerät geliefert werden. Dabei handelt es sich z.B. um Informationen zum Gerätetyp des realen Sensors (z.B. Information, welche Informationen für einen Imager in welchem Register stehen).
c) Ermitteln zumindest eines Charakteristikums des realen Sensors und/oder der zweiten Datenschnittstelle erster Art,
d) Konfigurieren der Sensorsimulation und/oder der ersten Datenschnittstelle erster Art anhand des zumindest einen Charakteristikums so, dass die synthetischen Sensordaten Sensordaten des realen Sensors simulieren.

In Schritt c) erfolgt das Ermitteln des zumindest einen Charakteristikums des realen Sensors und/oder der zweiten Datenschnittstelle erster Art anhand der ausgelesenen Aufzeichnung und/oder von in der Datenbank abgelegten Informationen.

Durch das beschriebene Verfahren kann somit die Handhabung der Konfiguration von Sensoren verbessert werden und es kann insbesondere ermöglicht werden, dass sich das Modul im Wesentlichen eigenständig konfigurieren kann, also z. B. automatisiert oder teilautomatisiert in einen lauffähigen Zustand versetzen kann.

Synthetische Sensordaten sind Daten, die durch die Sensorsimulation ausgegeben werden, um einen realen Sensor, z. B. Umgebungssensor, wie z. B. einen Kamerasensor, einen Radarsensor, einen Lidarsensor, einen Ultraschallsensor und/oder einen Infrarotsensor, zu simulieren. Die synthetischen Sensordaten können dabei vollständig oder teilweise durch die Sensorsimulation generiert sein. Bei einer vollständigen Generierung durch die Sensorsimulation werden die Sensordaten z. B. durch das Umgebungsmodell generiert. Bei einer teilweisen Generierung durch die Sensorsimulation kann es sich beispielsweise um zuvor aufgezeichnete Sensordaten, insbesondere reale aufgezeichnete Sensordaten, handeln, die durch die Sensorsimulation verändert, also z. B. angepasst und/oder ergänzt etc. werden, so dass sie z. B. den Sensordaten des realen Sensors (besser) entsprechen.

Das Gerät zur Ausführung von Steuerungs- und/oder Regelungsaufgaben kann dabei als Steuergerät ausgebildet sein oder einem Entwurfsstadium der Prototypenentwicklung entsprechen, welches seinerseits - je nach Stadium - als reine Software-Simulation ausgebildet sein kann. Entsprechend ist das Verfahren sowohl für Hardware-in-the-Loop Systeme als auch für Software-in-the-Loop Systeme anwendbar.

Bei der Aufzeichnung des Datenaustausches eines realen Sensors mit dem Gerät handelt es sich insbesondere um eine sog. Log-Datei der Daten, die über die entsprechende Kommunikationsverbindung über die zweite Datenschnittstelle erster Art zwischen dem realen Sensor und dem Gerät ausgetauscht wurden. Über die Kommunikationsverbindung werden in der Regel sowohl die Sensordaten als auch Konfigurationsdaten für die Datenschnittstelle erster Art ausgetauscht. über die gleiche Verbindung wie die Kommunikation kann optional auch die Energieversorgung für den Sensor realisiert werden, z. B. PoC (Power over Coax).

In einer Ausführungsform des Verfahrens sind die erste und die zweite Datenschnittstelle erster Art zum Datenaustausch unter Verwendung des gleichen Protokolls, insbesondere des Kommunikationsprotokolls, ausgebildet und eingerichtet. Die erste und die zweite Datenschnittstelle können z. B. auch die im Wesentlichen gleiche Hardwareausstattung aufweisen, also z. B. mit dem gleichen Typ Chip, Stecker etc. realisiert sein. Das in Schritt c) des Verfahrens ermittelte Charakteristikum kann dabei insbesondere einen Parameter des Protokolls der Datenschnittstelle erster Art betreffen, das durch den Verfahrensschritt d) angepasst wird. Zu den Datenschnittstellen gibt es z. B. von Seiten der Hersteller verschiedene Konfigurationsmöglichkeiten, wie z. B. Datenraten, Sensorschnittstellen usw. Bei einer Verbindung von Gerät mit realem Sensor kann der Sensor und/oder die zweite Datenschnittstelle erster Art über die Kommunikationsverbindung zwischen Gerät und realem Sensor konfiguriert werden. Durch Aufzeichnen und Auslesen dieser Kommunikation kann daher zumindest ein Charakteristikum gewonnen werden und die erste Datenschnittstelle erster Art in der Sensorsimulation entsprechend konfiguriert werden. Dies erspart insbesondere eine manuelle Konfiguration. Die Sensorsimulation kann daher einfacher, zuverlässiger und schneller an das Gerät angepasst werden.

Die Kommunikationsverbindung über die erste und die zweite Datenschnittstelle erster Art kann z. B. als serielle Datenverbindung ausgestaltet sein, bei der in der ersten und zweiten Datenschnittstelle erster Art die Daten durch einen Serialisierer, serialisiert werden und in einer Datenschnittstelle zweiter Art, z. B. im Gerät angeordnet, durch z. B. einen Deserialisierer wieder deserialisiert werden. Eine solche Schnittstelle ermöglicht eine gewisse Distanz zwischen dem Gerät und dem Sensor bzw. der Sensorsimulation, welche dann z. B. über eine Verbindung über ein Koaxialkabel überwunden werden kann. Mögliche Protokolle, die zur Anwendung kommen können, sind z. B. LVDS-Link, FPD-Link III, GMSL, MIPI A-PHY, MIPI D-PHY, ASA Motionlink, Ethernet, I2C, SPI, UART. Optional kann in Schritt c) auch ein Charakteristikum der Schnittstelle zweiter Art ermittelt werden und in Schritt d) kann optional auch die Schnittstelle zweiter Art konfiguriert werden.

Die Datenschnittstelle erster Art kann auch als reine Hardware-Schnittstelle oder elektrische Schnittstelle ausgebildet sein, die z. B. direkt auf dem Chip realisiert werden kann. Dies ist vorteilhaft für Realsierungen von Sensor/Sensorsimulation in räumlicher Nähe zum Gerät, z. B. im selben Gehäuse.

In einer Ausführungsform des Verfahrens wird das zumindest eine Charakteristikum durch das Auslesen der Aufzeichnung anhand von zumindest einer Eigenschaft des Protokolls, des realen Sensors und/oder der zweiten Datenschnittstelle erster Art ermittelt. Die Ermittlung anhand dieser Eigenschaft oder dieser Eigenschaften macht sich zunutze, dass unter Kenntnis des bei der Aufzeichnung zum Datenaustausch über die zweite Datenschnittstelle erster Art verwendeten Protokolls, des bei der Aufzeichnung verwendeten Sensors und/oder der bei der Aufzeichnung verwendeten zweiten Datenschnittstelle erster Art auch Kenntnisse (z. B. aus den empfangenen Informationen zur zumindest einen Eigenschaft) darüber vorliegen, wo in der Aufzeichnung welche Informationen zu finden sind, die dann als das Charakteristikum oder als die Charakteristiken verwendet werden können, um die Sensorsimulation und/oder die erste Datenschnittstelle erster Art zu konfigurieren. Z. B. kann eine Bezeichnung des Protokolls und/oder eine Information über die Art des Protokolls als Such- und/oder Entscheidungskriterium dienen, um das Charakteristikum aus der Aufzeichnung und/oder der Datenbank zu ermitteln.

In einer Ausführungsform wird die Sensorsimulation und/oder die erste Datenschnittstelle erster Art durch Schreiben zumindest eines Registers des Moduls konfiguriert, wobei der geschriebene Inhalt des Registers insbesondere von dem zumindest einen Charakteristikum abhängt und wobei die Auswahl des Registers und die Art, wie es beschrieben wird insbesondere von der zumindest einen Eigenschaft abhängt. Die Konfiguration erfolgt also insbesondere dadurch, dass die Konfiguration mit dem Charakteristikum erfolgt und anhand der zumindest einen Eigenschaft der Ort des Registers und das Format des Schreibens bestimmt wird.

In einer Ausführungsform wird in Verfahrensschritt d) ein Code, insbesondere ein ausführbarer Programmcode und/oder eine ausführbare Konfigurationsdatei, erzeugt, welcher bei Ausführung geeignet ist, die Konfiguration durchzuführen. Bei der Erzeugung des Codes kann es sich auch um die Parametrierung einer (auch nur in Teilen) bereits vorliegenden Konfigurationsdatei bzw. eines bereits vorliegenden Konfigurationscodes handeln. Dies ermöglicht eine weitere Automatisierung des Konfigurationsprozesses. Alternativ oder zusätzlich kann die Konfigurierung erfindungsgemäß auch über Ethernet (z.B. XCP, XIL-API) oder ähnliche Methoden erfolgen.

In einer Ausführungsform wird zum Ermitteln des zumindest einen Charakteristikums auf eine Datenbank zugegriffen und der Code in Abhängigkeit von einem durch die Datenbank zur Verfügung gestellten Daten-Inhalt generiert, wobei der von der Datenbank zur Verfügung gestellte Daten-Inhalt von der zumindest einen Eigenschaft abhängt. Diese Ausführungsform ermöglicht, das zumindest eine Charakteristikum, das von der zumindest einen Eigenschaft abhängen und für Schritt c) genutzt werden kann, nicht nur direkt durch das Auslesen der Aufzeichnung zu gewinnen, sondern auch zu ermöglichen, diese durch das Lesen von Einträgen der Datenbank zu gewinnen. Z.B. kann das Empfangen der Informationen zur Eigenschaft oder zu den Eigenschaften des realen Sensors und/oder der zweiten Datenschnittstelle erster Art durch einen Zugriff auf die Datenbank erfolgen, wo diese Informationen hinterlegt wurden.

In einer Ausführungsform wird zur Erzeugung des Codes auf die Datenbank zugegriffen und der Code in Abhängigkeit von einem durch die Datenbank zur Verfügung gestellten weiteren Daten-Inhalt generiert, wobei der von der Datenbank zur Verfügung gestellte weitere Daten-Inhalt von der zumindest einen Eigenschaft abhängt. Diese Ausführungsform ermöglicht, Kenntnisse, die von der zumindest einen Eigenschaft abhängen und die für Schritt d) genutzt werden können, nicht nur direkt durch das Auslesen der Aufzeichnung zu gewinnen, sondern auch zu ermöglichen, diese durch das Lesen von Einträgen der Datenbank zu gewinnen. Alternativ oder zusätzlich kann durch Verwendung von Einträgen der Datenbank die Codegenerierung beschleunigt werden.

Bei dem Daten-Inhalt kann es sich zu. B. um einen Temperaturwert handeln. Bei dem weiteren Daten-Inhalt kann es sich um den Daten-Inhalt ergänzende Informationen handeln, also - bezogen auf den Temperaturwert, z. B. um die Information, in welchem Format der Temperaturwert abgespeichert ist und/oder optional, dass es sich um einen Temperaturwert handelt.

Zur Codegenerierung kann es möglich sein, dass von einem Bediener des Moduls manuell Änderungen und/oder Ergänzungen des Codes vorgenommen werden, bevor der Code zum Zweck der Konfiguration zur Ausführung gebracht wird. Für solche Anwendungen ist in einer Ausführungsform vorgesehen, in einem Verfahrensschritt, einen Daten-Inhalt unter Verwendung der zumindest einen Eigenschaft so in die Datenbank zu schreiben, dass sie geeignet ist, in Abhängigkeit von der zumindest einen Eigenschaft von der Datenbank zur Verfügung gestellt zu werden. Hierdurch wird eine stetige Verbesserung der Datenbankinhalte ermöglicht.

Das zumindest eine Charakteristikum, mit welchem die Sensorsimulation und/oder die Datenschnittstelle erster Art konfiguriert wird, betrifft dabei z. B. eine Bildauflösung und/oder einen Farbraum der Sensorsimulation für einen Kamerasensor und/oder eine Generierung von Statistiken zu den durch die Sensorsimulation ausgegebenen synthetischen Bilddaten eines Kamerasensors. Die Generierung von Statistiken kann dabei insbesondere die Erzeugung eines Histogramms durch einen Imager, also einen Kamerasensor, betreffen. Hierbei wird ein Histogramm der Farb-/Pixel-Werte für jedes vom Sensor gesendete Bild im Imager berechnet und als sogenannte eingebettete Statistiken als zusätzliche Bildzeile an jedes Bild angehängt. Diese Funktion ist in der Regel standardmäßig deaktiviert und kann aber durch Konfiguration des Sensors aktiviert werden, z. B. durch einen Befehl über eine I2C-Schnittstelle. Durch das vorgeschlagene Verfahren kann dieses Charakteristikum "Histogrammgenerierung aktiviert" aus der Aufzeichnung ausgelesen werden und die Sensorsimulation entsprechend konfiguriert werden, indem auch in der Sensorsimulation die Histogrammgenerierung aktiviert wird.

Weitere Beispiele für das zumindest eine Charakteristikum betreffen die Temperatur des Sensors, den Frame Counter, also einen laufenden Zähler für jedes Bild eines Kamerasensors, die Frame Rate, also z. B. die Anzahl der Bilder pro Sekunde, und/oder Checksummen über Teile oder das gesamte Bild eines Kamerasensors.

Ein Modul zur Simulation zumindest eines Sensors weist Hardware und Software für eine Sensorsimulation und eine erste Datenschnittstelle erster Art auf, wobei die Sensorsimulation ausgebildet und eingerichtet ist, ein Gerät zur Ausführung von Steuerungs- und/oder Regelungsaufgaben über die erste Datenschnittstelle erster Art mit synthetischen Sensordaten zu versorgen.

Eine Vorrichtung zum Konfigurieren des Moduls zur Simulation kann eine Recheneinheit zur Ausführung eines Konfigurationsprogramms sein. Das Konfigurationsprogramm ist dabei insbesondere als eine Software mit Programmanweisungen ausgebildet. Bei Ausführung der Programmanweisungen wird das zuvor beschriebene Verfahren ausgeführt. Also z.B. ein PC, der mit dem Modul, z. B. einer ESI Unit (ESI Environment Sensor Unit), oder auch mehreren Modulen verbunden werden kann. Es kann auch vorgesehen sein, das Konfigurationsprogramm auf dem Modul auszuführen. Die Vorrichtung zum Konfigurieren des Moduls zur Simulation zumindest eines Sensors ist eingerichtet und ausgebildet:
eine Aufzeichnung eines Datenaustausches eines realen Sensors mit dem Steuergerät zu empfangen, wobei der Datenaustausch über eine zweite Datenschnittstelle erster Art erfolgte, und/oder Informationen zu zumindest einer Eigenschaft des realen Sensors (22) und/oder der zweiten Datenschnittstelle erster Art (24) zu empfangen,
die Aufzeichnung und/oder die Informationen zur zumindest einen Eigenschaft auszulesen,
zumindest ein Charakteristikum des realen Sensors und/oder der zweiten Datenschnittstelle erster Art zu ermitteln, und
die Sensorsimulation und/oder die erste Datenschnittstelle erster Art unter Verwendung des zumindest einen Charakteristikums so zu konfigurieren, dass die synthetischen Sensordaten Sensordaten des realen Sensors simulieren.

Das Gerät zur Ausführung von Steuerungs- und/oder Regelungsaufgaben kann als Steuergerät und/oder als Gerät zur Simulation eines Steuergerätes ausgebildet sein. Insbesondere können durch das Gerät verschiedene Stufen der Funktions- und Hardware-Entwicklung eines Steuergeräts verkörpert werden.

In einer Ausführungsform ist die Vorrichtung ausgebildet und eingerichtet, einen Code, insbesondere einen ausführbaren Programmcode und/oder eine ausführbare Konfigurationsdatei, zu erzeugen und durch Ausführen des Codes die Konfiguration durchzuführen. Hierfür weist die Vorrichtung eine Recheneinheit mit entsprechendem Speicher und entsprechenden Schnittstellen auf und ist mit einem entsprechenden Konfigurationsprogramm ausgestattet.

In einer Ausführungsform ist die Vorrichtung ausgebildet und eingerichtet, zum Ermitteln des zumindest einen Charakteristikums auf eine Datenbank zuzugreifen, wobei die Vorrichtung ausgebildet und eingerichtet ist, das zumindest eine Charakteristikum in Abhängigkeit von einem durch die Datenbank zur Verfügung gestellten Daten-Inhalt zu ermitteln, wobei der von der Datenbank zur Verfügung gestellte Daten-Inhalt von einer Eigenschaft des Protokolls, des realen Sensors und/oder der zweiten Datenschnittstelle erster Art abhängt.

In einer Ausführungsform ist die Vorrichtung ausgebildet und eingerichtet, zur Erzeugung des Codes, insbesondere des ausführbaren Programmcodes und/oder der ausführbaren Konfigurationsdatei, auf eine Datenbank zuzugreifen, wobei die Vorrichtung ausgebildet und eingerichtet ist, den Code in Abhängigkeit von einem durch die Datenbank zur Verfügung gestellten weiteren Daten-Inhalt zu generieren, wobei der von der Datenbank zur Verfügung gestellte weitere Daten-Inhalt von der Eigenschaft des Protokolls, des realen Sensors und/oder der zweiten Datenschnittstelle erster Art abhängt.

In einer Ausführungsform weist die Vorrichtung einen Speicher mit der Datenbank auf und/oder die Vorrichtung weist eine Kommunikationsschnittstelle zum Zugriff auf die Datenbank auf. Die Datenbank kann damit z. B. als Speicherbereich der Vorrichtung oder als externe Datenbank ausgebildet sein. Der Zugriff auf die externe Datenbank erfolgt z. B. über eine Schnittstelle. Die Datenbank kann auch an einem von der Vorrichtung entfernten Ort angeordnet sein und der Zugriff auf sie über Datenfernkommunikation erfolgen. Es sind auch Mischformen aus sog. internen und sog. externer Datenbank möglich. Eine Trennung kann hier z. B. nach Häufigkeit des Zugriffs erfolgen.

Eine Anordnung zur Simulation zumindest eines Sensors kann ein Modul zur Simulation zumindest eines Sensors und eine zuvor beschriebene Vorrichtung aufweisen. Die Vorrichtung kann dabei Bestandteil des Moduls sein oder kommunikativ mit diesem verbunden sein.

Die von dem Modul erzeugten synthetischen Sensordaten können dabei Sensordaten eines Kamerasensors, eines Radarsensors, eines Lidarsensors, eines Ultraschallsensors und/oder eines Infrarotsensors simulieren. In Ausführungsbeispielen des Moduls ist die Sensorsimulation also ausgebildet einen Kamerasensor, auch Bildsensor genannt, einen Radarsensor, einen Lidarsensor, einen Ultraschallsensor und/oder einen Infrarotsensor zu simulieren.

In einer Ausführungsform weist das Gerät zur Ausführung von Steuerungs- und/oder Regelungsaufgaben ein zuvor beschriebenes Modul auf. In diesem Ausführungsbeispiel erfolgt die Kommunikation zwischen dem Modul und dem Gerät über die erste Datenschnittstelle erster Art, welche z. B. als Hardware-Schnittstelle ausgebildet sein kann.

In einer weiteren Ausführungsform weist das Gerät zur Ausführung von Steuerungs- und/oder Regelungsaufgaben eine Datenschnittstelle zweiter Art zum Empfang von synthetischen Sensordaten von einem zuvor beschriebenen Modul auf. Die Datenschnittstelle zweiter Art kann z. B. als Deserialisierer ausgebildet sein. Die Datenschnittstelle zweiter Art kann in analoger Weise wie die Sensorsimulation und/oder die erste Datenschnittstelle erster Art durch das zuvor beschriebene Verfahren konfiguriert werden. Insbesondere kann aus der Aufzeichnung zumindest ein Charakteristikum zum Konfigurieren der Datenschnittstelle zweiter Art ermittelt werden. Es ist ebenfalls möglich, dass aus der Aufzeichnung zumindest ein Charakteristikum der Datenschnittstelle zweiter Art zu ermitteln, welches dann zur Konfiguration der ersten Datenschnittstelle erster Art verwendet werden kann.

### Figurenliste

Beispiele der Anmeldung werden nachfolgend bezugnehmend auf die beiliegenden Figuren beispielhaft näher erläutert. Es zeigen:
Fig. 1 schematisch ein Verfahren zum Konfigurieren;
Fig. 2 eine schematische Darstellung einer Ausführungsform einer Anordnung mit einer Vorrichtung zum Konfigurieren;
Fig. 3 eine schematische Darstellung einer weiteren Ausführungsform einer Anordnung mit einer Vorrichtung zum Konfigurieren;
Fig. 4 schematisch eine Ausführungsform eines Verfahrens zum Konfigurieren.

Es werden in den Figuren die gleichen Bezugszeichen für gleiche oder ähnliche Elemente verwendet.

### Figurenbeschreibung

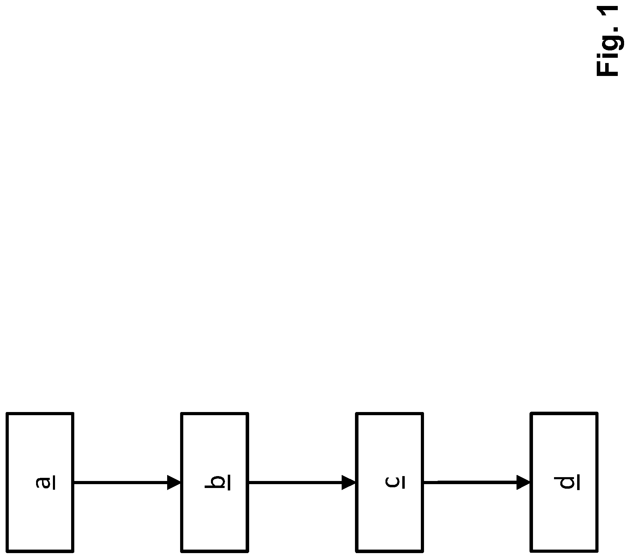

In Fig. 1 ist schematisch ein Verfahren zum Konfigurieren eines Moduls zur Simulation 12 zumindest eines Sensors dargestellt. Das Verfahren weist die Schritte auf:
a) Empfangen einer Aufzeichnung 20 eines Datenaustausches eines realen Sensors 22 mit einem Gerät 30 zur Ausführung von Steuerungs- und/oder Regelungsaufgaben, wobei der Datenaustausch über eine zweite Datenschnittstelle 24 erster Art erfolgte; und/oder Empfangen von Informationen zu zumindest einer Eigenschaft des realen Sensors 22 und/oder der zweiten Datenschnittstelle erster Art 24,
b) Auslesen der Aufzeichnung 20 und/oder der Informationen zur zumindest einen Eigenschaft. Optional erfolgt ein Verknüpfen der ausgelesenen Aufzeichnung mit den empfangenen Informationen zur zumindest einen Eigenschaft,
c) Ermitteln zumindest eines Charakteristikums Ch des realen Sensors 22 und/oder der zweiten Datenschnittstelle erster Art 24.
d) Konfigurieren einer Sensorsimulation 16 des Moduls 12 und/oder einer ersten Datenschnittstelle erster Art 14 des Moduls 12 anhand des zumindest einen Charakteristikums Ch.

Die Sensorsimulation 16 des Moduls 12 versorgt das Gerät 30 zur Ausführung von Steuerungs- und/oder Regelungsaufgaben über die erste Datenschnittstelle erster Art 14 mit synthetischen Sensordaten. Die Konfiguration in Schritt d) erfolgt so, dass die synthetischen Sensordaten Sensordaten des realen Sensors 22 simulieren. Dies bedeutet, dass das Gerät 30 die synthetischen Sensordaten von dem Modul 12 empfängt und diese genauso verarbeitet und auf diese genauso reagiert wie auf Sensordaten vom realen Sensor.

Die Informationen zur zumindest einen Eigenschaft des realen Sensors und/oder der zweiten Datenschnittstelle erster Art können z. B. in einer Konfigurationsspezifikation enthalten sein, welche z. B. dem realen Sensor und/oder dem Gerät zur Ausführung von Steuerungs- und/oder Regelungsaufgaben zugeordnet ist. Es ist möglich, zumindest Teile der in Schritt b) ausgelesenen Aufzeichnung und/oder empfangenen Informationen zur zumindest einen Eigenschaft in einer Datenbank DB abzulegen. Die Ermittlung des zumindest einen Charakteristikums Ch in Schritt c) kann dann anhand der ausgelesenen Aufzeichnung und/oder empfangenen Informationen zur zumindest einen Eigenschaft und/oder anhand der entsprechenden zuvor in der Datenbank abgelegten Daten DB erfolgen.

Es ist denkbar, die Konfiguration in Schritt d) durch die Ausführung von Softwarebefehlen eines Programmcodes auszuführen. Dieser Programmcode kann unter Verwendung des zumindest einen Charakteristikums Ch automatisch erzeugt sein oder im Falle einer Konfigurationsdatei automatisch parametriert sein. Das Charakteristikum Ch betrifft dabei Konfigurationsmöglichkeiten, also Einstellmöglichkeiten, der zweiten Schnittstelle erster Art 24 und/oder des realen Sensors 22. Insbesondere kann der Code unter Verwendung von Daten-Inhalten der Datenbank DB erzeugt werden. Auf die Datenbank DB kann insbesondere anhand einer Eigenschaft der zweiten Schnittstelle erster Art, z. B. Protokoll, verwendeter Chip etc., und/oder einer Eigenschaft des realen Sensors 22, z. B. Sensortyp, Hersteller etc., zugegriffen werden. Die Eigenschaft betrifft dabei insbesondere die Art oder den Typ der zweiten Datenschnittstelle erster Art 24 und/oder des realen Sensors 22 und das Charakteristikum betrifft insbesondere welche Konfiguration, also Einstellung, für spezifische Einstellmöglichkeiten für eine solche Schnittstelle erster Art 24 und/oder einen solchen Sensor 22 vorzunehmen sind.

Das mit dem automatisch erzeugten Code konfigurierte Modul 12 kann dann zum Testen mit dem Gerät 30 verbunden werden und so die Güte der Konfiguration ermittelt werden. Ist das Ergebnis noch nicht zufriedenstellend, kann z. B. der automatisch generierte Code entsprechend angepasst werden und das Modul 12 durch Ausführung des modifizierten Codes erneut konfiguriert werden. Das erneut konfigurierte Modul 12 kann dann erneut mit dem Gerät 30 verbunden werden und die Güte der Konfiguration anhand der von dem Modul 12 zur Verfügung gestellten synthetischen Sensordaten überprüft werden. Durch einen solchen iterativen Prozess können die Konfiguration und der Code, der zur Konfiguration ausgeführt wird, schrittweise verbessert werden. Der modifizierte Code kann dann in die Datenbank DB zurückgespeichert werden.

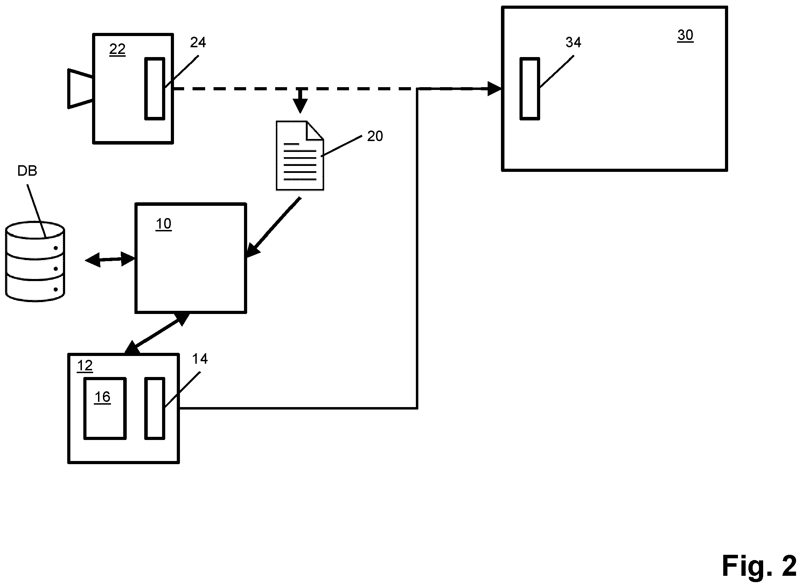

In Fig. 2 ist eine Ausführungsform einer Anordnung zum Konfigurieren des Moduls 12 zur Simulation zumindest eines Sensors mit der Vorrichtung zum Konfigurieren 10 des Moduls 12 zur Simulation dargestellt. Das Modul 12 weist Hardware und Software für die Sensorsimulation 16 und die erste Datenschnittstelle erster Art 14 auf, welche insbesondere als Serialisierer ausgebildet sein kann. Die Sensorsimulation 16 ist ausgebildet und eingerichtet, das Gerät 30 zur Ausführung von Steuerungs- und/oder Regelungsaufgaben über die erste Datenschnittstelle erster Art 14 mit synthetischen Sensordaten zu versorgen. Hierfür gibt die Sensorsimulation die synthetischen Sensordaten über die erste Schnittstelle erster Art 24 aus. Das Gerät 30 kann als Steuergerät und/oder als Gerät zur Simulation eines Steuergerätes ausgebildet sein. Es empfängt die synthetischen Sensordaten über die Datenschnittstelle zweiter Art 34, welche insbesondere als Deserialisierer ausgebildet sein kann.

In Fig. 2 ist mit gestrichelter Linie die Verbindung des realen Sensors 22 mit dem Gerät 30 dargestellt. Über diese Verbindung, welche z. B. durch ein Kabel wie ein Koaxialkabel hergestellt werden kann, findet der Datenaustausch des realen Sensors 22 mit dem Gerät 30 statt. Der reale Sensor 22 gibt dabei Sensordaten über die zweite Schnittstelle erster Art 24, z. B. einen Serialisierer, aus. Die Sensordaten werden von dem Gerät 30 über die Schnittstelle zweiter Art 34, z. B. einen Deserialisierer, empfangen. Ein solcher Datenaustausch des realen Sensors 22 mit dem Gerät 30 wird aufgezeichnet und die Aufzeichnung 20 an die Vorrichtung 10 übertragen. Eine solche Aufzeichnung 20 kann z. B. direkt über eine Log-Datei und/oder über eine spezielle Schnittstelle, z. B. Debug-Schnittstelle, des Gerätes 30 und/oder des Sensors 22 erfolgen. Für die Aufzeichnung 20 können die Daten beispielsweise an der zweiten Schnittstelle erste Art 24 oder an der Schnittstelle zweiter Art 34 oder aber, wie in Figur 2 angedeutet, über eine Schnittstelle in der Verbindung zwischen Sensor 22 und Gerät 30 aufgenommen bzw. abgegriffen werden. Eine solche Aufzeichnung gemäß Schritt a) des Verfahrens muss nicht für jeden Konfigurationsvorgang neu erfolgen. Die Aufzeichnung und/oder die Konfigurationsspezifikation kann nur einmal eingelesen werden und dann für mehrere zeitlich aufeinanderfolgende Tests oder für mehrere parallele Tests von Steuergeräten gleicher Bauart und Konfiguration verwendet werden.

Die Vorrichtung 10 ist eingerichtet und ausgebildet, die Aufzeichnung 20 auszulesen, das zumindest eine Charakteristikum Ch des realen Sensors 22 und/oder der zweiten Datenschnittstelle erster Art 24 aus der Aufzeichnung zu ermitteln, und die Sensorsimulation 16 und/oder die erste Datenschnittstelle erster Art 14 unter Verwendung des zumindest einen Charakteristikums Ch so zu konfigurieren, dass die synthetischen Sensordaten Sensordaten des realen Sensors 22 simulieren. Hierbei wird sich zunutze gemacht, dass die erste und die zweite Datenschnittstelle 14, 24 von der gleichen Art sind. Das Modul 12 soll den realen Sensor 22 möglichst genau simulieren, so dass für die Konfiguration auf die Aufzeichnung 20 zurückgegriffen wird, um für das Gerät 30 synthetische Sensordaten zur Verfügung zu stellen, die den realen Sensordaten des realen Sensors 22 möglich nahe kommen und vorzugsweise nahezu identisch sind.

Die Hardware für die Sensorsimulation 16 kann z. B. als FPGA-Board ausgebildet sein, welches mittels der Software für die Sensorsimulation 16 programmiert wird. Als Hardware für die Sensorsimulation 16 kann auch eine GPU (Graphic Processing Unit) verwendet werden, bei welcher z. B. die Farbausgabe konfiguriert wird. Die Die Vorrichtung 10 ist ausgebildet und eingerichtet, einen Code zu erzeugen und durch Ausführen des Codes die Konfiguration durchzuführen, wobei zur Erzeugung des Codes auf eine Datenbank DB mit Daten für die Schnittstellen und den zumindest einen Sensor und weiterer Komponenten zugegriffen wird.

Die Vorrichtung 10 kann einen Speicher mit der Datenbank DB aufweisen und/oder die Vorrichtung 10 kann eine Kommunikationsschnittstelle zum Zugriff auf die Datenbank DB aufweisen. Die Datenbank kann insbesondere als zentrale Datenbank in der sogenannten "Datenwolke" oder einer Zentrale - zum Zugriff für mehrere Vorrichtungen 10 - angeordnet sein.

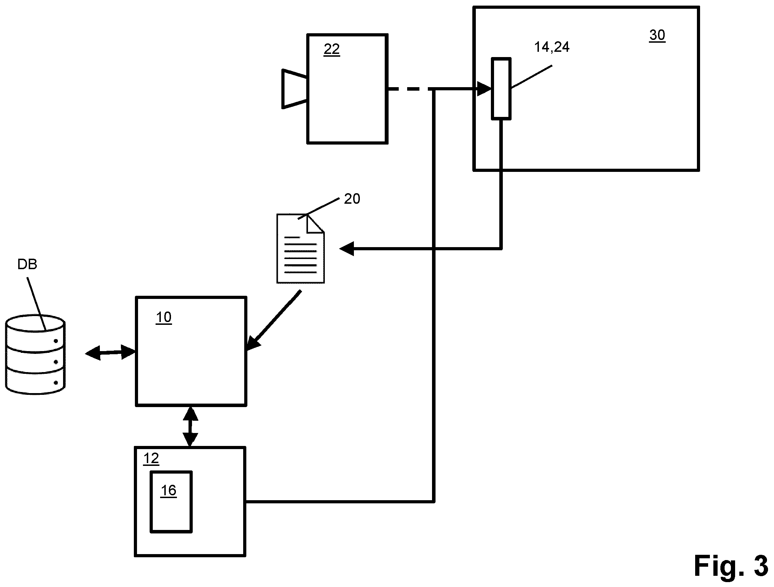

In Fig. 3 ist eine weitere Ausführungsform einer Anordnung zum Konfigurieren des Moduls 12 zur Simulation zumindest eines Sensors mit der Vorrichtung zum Konfigurieren 10 des Moduls 12 zur Simulation dargestellt. Das Modul 12 weist Hardware und Software für die Sensorsimulation 16 und die erste Datenschnittstelle erster Art 14 auf. Im in Fig. 3 dargestellten Ausführungsbeispiel ist die erste Datenschnittstelle erster Art 14 in dem Gerät 30 angeordnet und identisch mit der zweiten Datenschnittstelle erster Art 24.

Die Sensorsimulation 16 ist ausgebildet und eingerichtet, das Gerät 30 zur Ausführung von Steuerungs- und/oder Regelungsaufgaben über die erste Datenschnittstelle erster Art 14, 24 mit synthetischen Sensordaten zu versorgen. Hierfür gibt die Sensorsimulation die synthetischen Sensordaten über die erste Schnittstelle erster Art 14 aus. Das Gerät 30 kann als Steuergerät und/oder als Gerät zur Simulation eines Steuergerätes ausgebildet sein. Es empfängt die synthetischen Sensordaten über die erste Datenschnittstelle erster Art 14, 24. Optional kann das Modul 12 im Gerät 30 angeordnet sein und z. B. im selben Gehäuse angeordnet sein.

Das Gerät 30 weist in diesem Ausführungsbeispiel keine Datenschnittstelle zweiter Art auf. Die Datenschnittstelle erster Art 14, 24 ist z. B. als Hardwareschnittstelle mit z. B. einer Steckverbindung ausgestaltet.

Der Empfang von Sensordaten von dem realen Sensor 22 erfolgt über die eine Datenschnittstelle erster Art 14, 24 - in Fig. 3 mit der gestrichelten Linie dargestellt. Der reale Sensor 22 kann im Betrieb mit dem realen Sensor 22 direkt über die Datenschnittstelle erster Art 14, 24 mit dem Gerät 30 verbunden werden und optional im Gerät 30 integriert sein. Über diese Verbindung findet der Datenaustausch des realen Sensors 22 mit dem Gerät 30 statt. Ein solcher Datenaustausches des realen Sensors 22 mit dem Gerät 30 wird aufgezeichnet und die Aufzeichnung 20 an die Vorrichtung 10 übertragen.

Die Vorrichtung 10 ist eingerichtet und ausgebildet, die Aufzeichnung 20 auszulesen, das zumindest eine Charakteristikum Ch des realen Sensors 22 aus der Aufzeichnung zu ermitteln, und die Sensorsimulation 16 unter Verwendung des zumindest einen Charakteristikums Ch so zu konfigurieren, dass die synthetischen Sensordaten Sensordaten des realen Sensors 22 simulieren. In diesem Ausführungsbeispiel kann auf die Konfiguration der ersten und der zweiten Datenschnittstelle 14, 24 verzichtet werden, da es sich um die gleiche Datenschnittstelle erster Art 14, 24 handelt.

Die Sensorsimulation 16 des Moduls 12 ist eingerichtet, Sensordaten eines Kamerasensors, eines Radarsensors, eines Lidarsensors, eines Ultraschallsensors und/oder eines Infrarotsensors zu simulieren und als synthetische Sensordaten auszugeben.

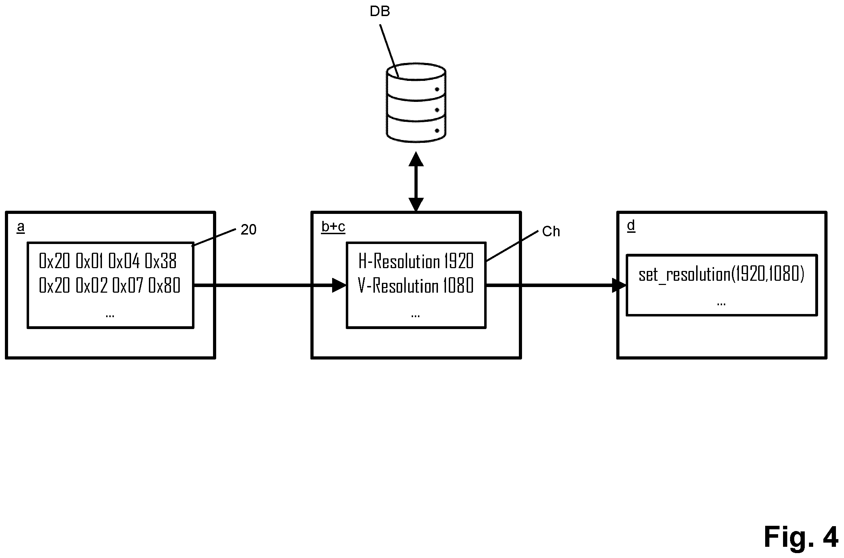

Fig. 4 zeigt schematisch eine Ausführungsform eines Verfahrens zum Konfigurieren unter Verwendung automatisch generierten Codes.

Die Aufzeichnung 20 ist im dargestellten Beispiel ein I2C-Log mit zwei Zugriffen mit Device-Adresse 0x20 auf einen Imager, also einen Kamerasensor. Zugegriffen wird einmal auf Register 0x01 und einmal auf Register 0x02. Die Aufzeichnung 20 wird in Schritt b) ausgelesen und in Schritt c) automatisch analysiert. Im dargestellten Beispiel ergibt sich daraus, dass es sich um I2C-Zugriffe auf zwei Register der horizontalen (0x07, 0x08) und vertikalen Bildauflösung (0x04, 0x38) handelt. Die Auflösung wird daraufhin durch Zugriff auf die in der Datenbank DB hinterlegten Registerbeschreibung des entsprechenden Imagers ermittelt. Es wird also unter Verwendung der Register-Adresse des Imager-Typs als Eigenschaft auf die Datenbank zugegriffen. Es ergibt sich als Charakteristikum Ch eine Bildauflösung (horizontal x vertikal) von 1920x1080.

In Schritt d) wird der entsprechende Code, z. B. C++-Code generiert und die Konfiguration durch Ausführung des Codes durchgeführt.

### Bezugszeichenliste

- 10: Vorrichtung zum Konfigurieren
- 12: Modul zur Simulation
- 14: erste Datenschnittstelle erster Art
- 16: Sensorsimulation
- 20: Aufzeichnung
- 22: realer Sensor
- 24: zweite Datenschnittstelle erster Art
- 30: Gerät
- 34: Datenschnittstelle zweiter Art
- Ch: Charakteristikum
- DB: Datenbank
- a, b, c, d: Verfahrensschritte

## Patentansprüche

1. Verfahren zum Konfigurieren eines Moduls zur Simulation (12) zumindest eines Sensors, wobei das Modul (12) eine Sensorsimulation (16) und eine erste Datenschnittstelle (14) erster Art aufweist, wobei die Sensorsimulation (16) ausgebildet und eingerichtet ist, ein Gerät (30) zur Ausführung von Steuerungs- und/oder Regelungsaufgaben über die erste Datenschnittstelle (14) erster Art mit synthetischen Sensordaten zu versorgen, wobei das Verfahren die Schritte aufweist:
a) Empfangen einer Aufzeichnung (20) eines Datenaustausches eines realen Sensors (22) mit dem Gerät (30), wobei der Datenaustausch über eine zweite Datenschnittstelle (24) erster Art erfolgte, und/oder Empfangen von Informationen zu zumindest einer Eigenschaft des realen Sensors (22) und/oder der zweiten Datenschnittstelle erster Art (24),
b) Auslesen der Aufzeichnung (20) und/oder der Informationen zur zumindest einen Eigenschaft,
c) Ermitteln zumindest eines Charakteristikums (Ch) des realen Sensors (22) und/oder der zweiten Datenschnittstelle erster Art (24),
d) Konfigurieren der Sensorsimulation (16) und/oder der ersten Datenschnittstelle erster Art (14) unter Verwendung des zumindest einen Charakteristikums (Ch) so, dass die synthetischen Sensordaten Sensordaten des realen Sensors (22) simulieren.

2. Verfahren nach Anspruch 1, wobei die erste und die zweite Datenschnittstelle erster Art (14, 24) zum Datenaustausch unter Verwendung des gleichen Protokolls ausgebildet und eingerichtet sind, wobei die erste und die zweite Datenschnittstelle erster Art (14, 24) insbesondere als Serialisierer ausgebildet sind.

3. Verfahren nach Anspruch 2, wobei das zumindest eine Charakteristikum (Ch) durch das Auslesen der Aufzeichnung (20) anhand von der zumindest einen Eigenschaft des Protokolls, des realen Sensors (22) und/oder der zweiten Datenschnittstelle erster Art (24) ermittelt wird.

4. Verfahren nach Anspruch 3, wobei die Sensorsimulation (16) und/oder die erste Datenschnittstelle erster Art (14) durch Schreiben zumindest eines Registers des Moduls (12) konfiguriert wird, wobei der geschriebene Inhalt des Registers von dem zumindest einen Charakteristikum (Ch) abhängt und wobei die Auswahl des Registers von der zumindest einen Eigenschaft abhängt.

5. Verfahren nach einem der vorhergehenden Ansprüche, wobei in Verfahrensschritt d) ein Code, insbesondere ein ausführbarer Programmcode und/oder eine Konfigurationsdatei, erzeugt wird, welcher bei Ausführung geeignet ist, die Konfiguration durchzuführen.

6. Verfahren nach einem der vorhergehenden Ansprüche, wobei zum Ermitteln des zumindest einen Charakteristikums (Ch) und/oder zur Erzeugung des Codes auf eine Datenbank (DB) zugegriffen wird, wobei das zumindest eine Charakteristikum (CH) in Abhängigkeit von einem durch die Datenbank (DB) zur Verfügung gestellten Daten-Inhalt ermittelt wird und /oder der Code in Abhängigkeit von einem durch die Datenbank (DB) zur Verfügung gestellten weiteren Daten-Inhalt generiert wird,
wobei der von der Datenbank (DB) zur Verfügung gestellte Daten-Inhalt und/oder weitere Daten-Inhalt von der zumindest einen Eigenschaft abhängt.

7. Verfahren nach einem der vorhergehenden Ansprüche, wobei in einem Verfahrensschritt vorgesehen ist, einen Daten-Inhalt unter Verwendung der zumindest einen Eigenschaft so in die Datenbank (DB) zu schreiben, dass er geeignet ist, anhand der zumindest einen Eigenschaft von der Datenbank (DB) zur Verfügung gestellt zu werden, wobei der Daten-Inhalt insbesondere von der in Schritt b) ausgelesenen Aufzeichnung und/oder den in Schritt b) ausgelesenen Informationen zu der zumindest einen Eigenschaft abhängt.

8. Vorrichtung zum Konfigurieren (10) eines Moduls zur Simulation (12) zumindest eines Sensors, wobei das Modul (12) Hardware und Software für eine Sensorsimulation (16) und eine erste Datenschnittstelle erster Art (14) aufweist, wobei die Sensorsimulation (16) ausgebildet und eingerichtet ist, ein Gerät (30) zur Ausführung von Steuerungs- und/oder Regelungsaufgaben über die erste Datenschnittstelle erster Art (14) mit synthetischen Sensordaten zu versorgen, wobei die Vorrichtung (10) eingerichtet und ausgebildet ist,
eine Aufzeichnung (20) eines Datenaustausches eines realen Sensors (22) mit dem Gerät (30) zu empfangen, wobei der Datenaustausch über eine zweite Datenschnittstelle erster Art (24) erfolgte, und/oder Informationen zu zumindest einer Eigenschaft des realen Sensors (22) und/oder der zweiten Datenschnittstelle erster Art (24) zu empfangen,
die Aufzeichnung (20) und/oder die Informationen zur zumindest einen Eigenschaft auszulesen,
zumindest ein Charakteristikum (Ch) des realen Sensors (22) und/oder der zweiten Datenschnittstelle erster Art (24) zu ermitteln, und
die Sensorsimulation (16) und/oder die erste Datenschnittstelle erster Art (14) unter Verwendung des zumindest einen Charakteristikums (Ch) so zu konfigurieren, dass die synthetischen Sensordaten Sensordaten des realen Sensors (22) simulieren.

9. Vorrichtung (10) zum Konfigurieren nach Anspruch 8, wobei das Gerät (30) als Steuergerät und/oder als Gerät zur Simulation eines Steuergerätes ausgebildet ist.

10. Vorrichtung zum Konfigurieren nach Anspruch 8 oder 9, wobei die Vorrichtung (10) ausgebildet und eingerichtet ist, einen Code, insbesondere einen ausführbaren Programmcode und/oder eine Konfigurationsdatei, zu erzeugen und durch Ausführen des Codes die Konfiguration durchzuführen.

11. Vorrichtung nach Anspruch 10, wobei die Vorrichtung (10) ausgebildet und eingerichtet ist, zum Ermitteln des zumindest einen Charakteristikums (Ch) und/oder zur Erzeugung des Codes auf eine Datenbank (DB) zuzugreifen, wobei die Vorrichtung ausgebildet und eingerichtet ist
das zumindest eine Charakteristikum (Ch) in Abhängigkeit von einem durch die Datenbank (DB) zur Verfügung gestellten Daten-Inhalt zu ermitteln und/oder den Code in Abhängigkeit von einem durch die Datenbank (DB) zur Verfügung gestellten weiteren Daten-Inhalt zu generieren,
wobei der von der Datenbank (DB) zur Verfügung gestellte Daten-Inhalt und/oder weitere Daten-Inhalt von der zumindest einen Eigenschaft abhängt.

12. Vorrichtung nach Anspruch 11, wobei die Vorrichtung (10) einen Speicher mit der Datenbank (DB) aufweist und/oder die Vorrichtung (10) eine Kommunikationsschnittstelle zum Zugriff auf die Datenbank (DB) aufweist.

13. Modul zur Simulation (12) zumindest eines Sensors mit einer Vorrichtung (10) nach einem Ansprüche 8 bis 12.

14. Modul nach Anspruch 13, wobei die synthetischen Sensordaten Sensordaten eines Kamerasensors, eines Radarsensors, eines Lidarsensors, eines Ultraschallsensors und/oder eines Infrarotsensors simulieren.

15. Gerät (30) zur Ausführung von Steuerungs- und/oder Regelungsaufgaben, welches ein Modul (12) nach Anspruch 13 oder 14 aufweist oder welches eine Datenschnittstelle (34) zweiter Art zum Empfang von synthetischen Sensordaten von einem Modul (12) nach Anspruch 13 oder 14 aufweist.
